# FASCICULE DE BREVET EUROPEEN

(11) **EP 0 712 163 B1**
(45) Date de publication et mention de la délivrance du brevet: **14.07.2004**
(21) Numéro de dépôt: 95402489.9
(22) Date de dépôt: 07.11.1995
(51) Int. Cl.: H01L 27/115, H01L 27/12, H01L 29/788

(54) **Dispositif à mémoire non-volatile électriquement effaçable et procédé de réalisation d'un tel dispositif**
Elektrisch löschbares nicht-flüchtiges Speicherbauteil und Verfahren zur Herstellung desselben
Electrically erasable non-volatile memory device and method of manufacturing such a device

(30) Priorité: 10.11.1994 FR 9413556
(43) Date de publication de la demande: 15.05.1996
(73) Titulaire: COMMISSARIAT A L'ENERGIE ATOMIQUE, 75015 Paris (FR)
(72) Inventeur: Hartmann, Joel, F-38640 Claix (FR)
(74) Mandataire: Poulin, Gérard

(56) Documents cités:
- WO-A-94/23444
- US-A- 5 313 086
- PATENT ABSTRACTS OF JAPAN vol. 016 no. 188 (E-1198) ,7 Mai 1992 & JP-A-04 025077 (SEIKO INSTR INC) 28 Janvier 1992,

## Description

### Domaine technique

La présente invention concerne un dispositif à mémoire non-volatile, électriquement effaçable, ainsi qu'un procédé de réalisation d'un tel dispositif. Elle concerne plus particulièrement un dispositif de mémoire du type à isolation électrique totale. On entend par isolation électrique totale, une isolation électrique autorisant la programmation indépendante des différentes parties du plan mémoire d'un circuit à mémoire. Une telle isolation permet notamment de polariser de manière spécifique certains composants de mémoire sans perturber le fonctionnement du reste du circuit. Elle permet également d'augmenter la tenue et la fiabilité des composants de mémoire lorsqu'ils sont soumis à des rayonnements ionisants tels que les rayons X, gamma et ions lourds.

L'invention trouve des applications notamment dans les cartes mémoires de calculateurs portables et les mémoires embarquées dans les satellites en remplacement de mémoires EPROM.

### Etat de la technique antérieure

A l'inverse des mémoires à accès aléatoires du type SRAM (Static Random Access Memory) ou DRAM (Dynamic Random Access Memory), il n'existe pas encore pour les mémoires non-volatiles de type Flash-EPROM (Erasable Programmable Read-Only Memory) ou flash-EEPROM (Electrically Erasable Read-Only Memory) de structure de point mémoire standard, ni de fonctionnement standard. Cela est dû essentiellement au fait que cette génération de produit est encore jeune, mais aussi au problème de l'effacement électrique des cellules ou points mémoire, qui reste le plus difficile à résoudre. Ce problème est à l'origine de la plupart des difficultés rencontrées pour les composants actuels.

Les documents (1) et (2) référencés à la fin de la présente description donnent plus de détails concernant les points mémoire et leur mode d'effacement.

On connaît également les points de mémoire de type ETOX (EPROM with Thin Oxide) qui permettent un effacement par application d'une tension sur la source des transistors formant ces points mémoire. On peut se reporter à ce sujet au document (3) référencé à la fin de la présente description. Ces dispositifs ont l'avantage d'être simples à réaliser et de bénéficier d'une compatibilité technologique presque totale avec les mémoires EPROM ; ce qui est important pour les fabricants de semi-conducteurs déjà spécialisés dans ce domaine. Ils posent par contre un problème de consommation électrique et de fiabilité : en effet, la tension d'effacement appliquée sur la source doit être de l'ordre de grandeur de la tension de programmation en écriture soit environ 12 à 13V. Cette tension est aussi de l'ordre de grandeur de la tension d'avalanche de la jonction source-substrat et engendre donc, pendant la phase d'effacement, un courant de fuite important et par conséquent une consommation électrique souvent incompatible avec des applications de type ordinateur portable. Pour pallier ce problème, il est également possible de n'appliquer qu'une faible tension positive sur la source (de 0 à 5V) et d'appliquer le reste sous forme d'une tension négative sur la grille de commande. Ceci nécessite généralement d'augmenter la tension appliquée sur la grille de commande au-dessus de 15V en valeur absolue. La génération d'une tension négative sur un circuit intégré n'est pas réalisable simplement et nécessite une partie de circuit dédiée à cet effet. La surface occupée par le dispositif permettant de générer cette tension négative peut atteindre plusieurs mm² soit un pourcentage non négligeable de la surface totale du circuit. Ceci constitue un handicap considérable pour l'augmentation de la densité d'intégration.

Les documents (6) et (7), dont les références sont précisées à la fin de la description concernent également des structures à élément de mémoire.

Le document (6) montre une structure avec un élément de mémoire réalisé sur un substrat de type SOI. Cet élément est électriquement indépendant (flottant).

Le document (7) montre un composant de mémoires à semiconducteur réalisé dans un premier caisson semiconducteur ménagé dans un substrat massif et isolé du substrat par un deuxième caisson qui l'entoure. L'effacement de la mémoire a lieu par l'application sur le premier caisson d'une tension.

Un des objets de la présente invention est de proposer un dispositif de mémoire, ne présentant pas les inconvénients ci-dessus et qui permette la programmation indépendante de différentes parties de la mémoire.

Un autre objet est de proposer un procédé de réalisation d'un tel dispositif qui soit à la fois simple et compatible avec les exigences d'une augmentation de la densité d'intégration des circuits.

### Exposé de l'invention

A cet effet, l'invention telle que revendiquée dans la revendication 1 concerne plus précisément un dispositif à mémoire non-volatile, électriquement effaçable, comportant dans au moins une partie d'un substrat, dite zone de mémoire, au moins un point mémoire du type à grille flottante comprenant une source et un drain séparés par une région de canal, caractérisé en ce qu'il comporte un seul moyen de polarisation du substrat formé par des moyens d'application d'une tension d'effacement du point mémoire dans la région de canal et en ce que le substrat est formé par la couche supérieure d'une structure SOI (silicium sur isolant) et est d'un type de conductivité unique.

Le dispositif de l'invention peut comporter une pluralité de zones de mémoire mutuellement isolées par des moyens d'isolation électriques.

Un adressage particulier pour chaque zone de mémoire peut être prévu. Dans ce cas, les moyens d'application d'une tension d'effacement comportent, par exemple, pour chaque zone de mémoire, une ligne de connexion reliée à la partie de substrat correspondant à la zone de mémoire, pour appliquer la tension d'effacement dans la ou les région(s) de canal par l'intermédiaire du substrat.

Cette ligne permet, conformément à l'invention, d'appliquer sélectivement à la partie du substrat correspondante, une tension d'effacement du ou des point(s) mémoire situé(s) dans cette partie.

Des lignes de connexion reliées aux grille(s), source(s) et drain(s) du ou des point(s) mémoire sont également prévues.

Les moyens d'isolation électrique permettent notamment d'éviter des perturbations mutuelles entre les zones de mémoire, en particulier lors d'opérations d'écriture et/ou d'effacement.

Selon un aspect particulier de l'invention les moyens d'isolation électrique comportent des tranchées d'isolation gravées dans le substrat.

De plus, le substrat présentant une structure du type silicium sur isolant (SOI, Silicon on Insulator), les tranchées sont gravées dans le silicium et présentent une profondeur suffisante pour atteindre l'isolant, de façon à former dans le substrat des caissons isolés correspondant aux zones de mémoire.

L'invention concerne également un procédé de réalisation d'un dispositif tel que décrit ci-dessus.

Le procédé comporte pour l'essentiel les étapes suivantes :
- formation d'un substrat par la réalisation d'une couche semi-conductrice active sur un empilement formé par une couche isolante électrique et un support,
- formation dans la couche active, de régions, dites caissons, respectivement de type N et/ou de type P,
- formation dans la couche active de tranchées d'isolation séparant les caissons et s'étendant jusque sur la couche isolante,
- réalisation d'un ou de plusieurs points mémoire dans les caissons, les points comprenant respectivement un drain et une source formés par implantation d'ions dans la couche active de part et d'autre d'une région de canal, ainsi qu'une grille flottante et une grille de commande, mutuellement isolées, formées à la surface de la couche active,
- réalisation de lignes de connexion reliées respectivement au drain, à la source et à la grille de commande de chaque point mémoire et à la couche semi-conductrice active de chaque caisson.

On entend par caissons des parties de la couche actives présentant une conductivité soit N, soit P. Les caissons sont délimités par les tranchées qui les séparent et les isolent mutuellement.

D'autres caractéristiques et avantages de l'invention ressortiront de la description qui va suivre, en référence aux figures annexées et données à titre purement illustratif et non limitatif.

### Brève description des figures

- la figure 1 est une coupe schématique d'un dispositif à mémoire conforme à l'invention,
- la figure 2 est une vue de dessus avec un écorché partiel, du dispositif de la figure 1,
- la figure 3 est une vue schématique de dessus d'un dispositif selon l'invention comportant une pluralité de points mémoire,
- la figure 4 est une coupe IV-IV d'un détail de la figure 3,
- la figure 5 est une coupe transversale d'un détail d'une variante de réalisation du dispositif de la figure 3,
- la figure 6 est une coupe selon VI-VI du dispositif de la figure 3,
- la figure 7 est un schéma électronique d'un dispositif conforme à l'invention, et
- les figures 8 à 10 sont des coupes transversales schématiques illustrant des étapes de fabrication d'un dispositif conforme à l'invention.

Pour faciliter leur lecture toutes les figures ne sont pas représentées à la même échelle.

### Description détaillée de modes de réalisation de la présente invention

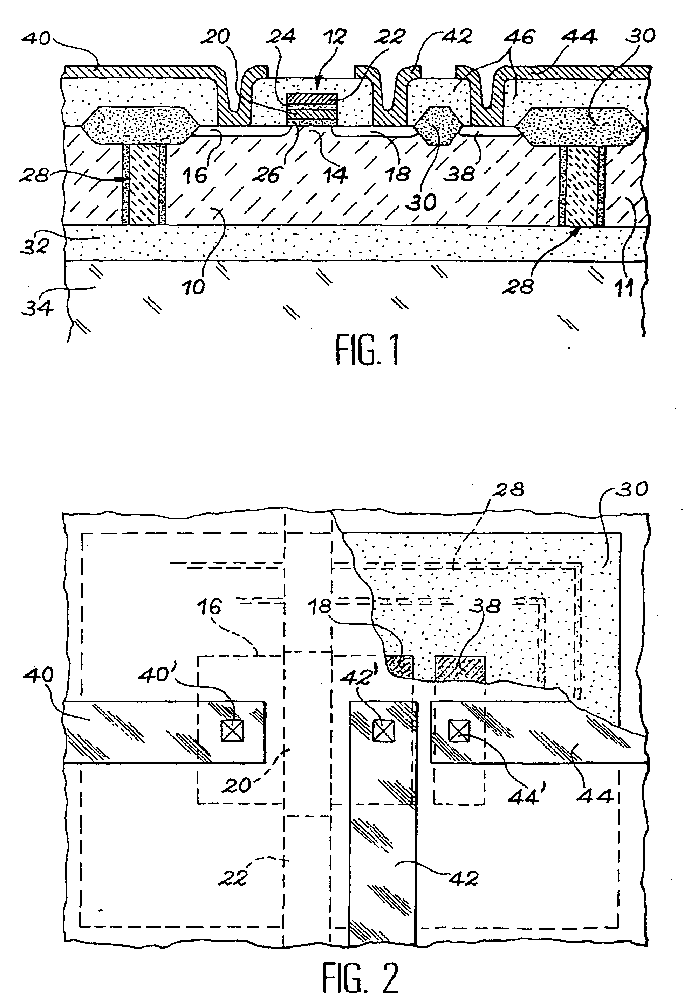

Le dispositif représenté à la figure 1 comporte dans une zone de mémoire définie par une partie du substrat 10 dite caisson, un point mémoire 12 avec une région de canal 14, une source 16, un drain 18, une grille flottante 20 et une grille de commande 22. Des couches isolantes 24, 26 séparent respectivement les grilles entre elles et les grilles de la région de canal 14. Les composants formés dans le caisson 10, de type P par exemple sont électriquement isolés de caissons voisins 11 grâce à des tranchées d'isolation 28. Les tranchées 28 sont avantageusement surmontées par des zones 30 d'oxyde de champ pour délimiter les zones de mémoire. Une couche enterrée 32 isolante, par exemple d'oxyde de silicium contribue également à l'isolation mutuelle des caissons 10, 11 et à leur isolation par rapport à un substrat de support 34 en silicium par exemple.

Conformément à l'invention, le dispositif comporte des moyens 38, 44 de polarisation (ou d'application d'une tension d'effacement) de la région de canal par l'intermédiaire du substrat 10. Dans le cas de la figure où le caisson 10 est du type de conduction P, c'est-à-dire dopé avec des impuretés acceptrices telles que du bore, les moyens 38 comportent une prise de contact électrique avec le caisson 10 réalisé par une région 38 fortement dopée P formée par implantation dans le caisson 10. La région 38 est avantageusement séparée du drain 18 également par un oxyde de champ 30. On peut remarquer sur la figure des lignes de connexion en métal 40, 42, 44 reliées respectivement à la source 16, au drain 18 et à la région 38. Ces lignes sont isolées par rapport au point mémoire par une couche de diélectrique 46.

Les grilles peuvent également être pourvus d'une ligne de connexion, mais dans le cas de la figure, cette ligne est directement formée par la grille de commande 22.

La ligne de connexion 44 et la région 38 permettent d'appliquer au caisson et par conséquent à la région de canal une tension d'effacement du point mémoire.

La figure 2 est une vue de dessus du dispositif de la figure 1 ; elle permet de mieux voir les lignes 40, 42, 44. Les prises de contact de ces lignes sur les source, drain et région 38 sont symboliquement représentées avec les références 40', 42' et 44'.

La source 16, le drain 18, la région 38 et les tranchées 28 apparaissent également sur la figure. La grille flottante 20 est un pavé formé sous la grille de commande 22.

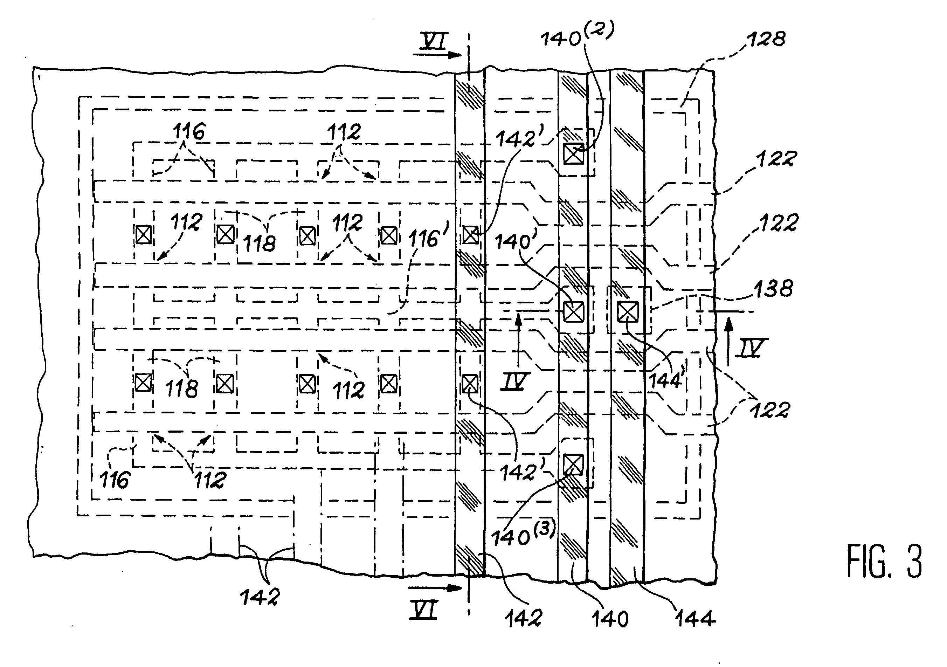

Alors que la figure 2 ne montre qu'un seul point mémoire, la figure 3 donne un exemple de mise en oeuvre de l'invention où la zone de mémoire, c'est-à-dire le caisson, comporte une pluralité de points mémoire matricés.

Le dispositif de la figure 3 comporte vingt points mémoire référencés 112, ces points mémoire sont agencés en quatre rangées définies par des grilles de commande formées par des lignes 122 correspondant respectivement aux points 112.

De part et d'autre des grilles de commande, on retrouve des régions de source référencées 116, 116' et des régions de drain référencées 118.

Pour des raisons de clarté, les références ne sont pas rappelées pour des motifs de points mémoire se répétant à l'identique.

Les sources 116' sont reliées entre elles et sont reliées à une ligne d'interconnexion 140 en une prise de connexion 140'. De même, les sources 116 sont reliées entre elles et à la ligne d'interconnexion 140 respectivement par les prises de contact 140⁽²⁾ et 140⁽³⁾.

Les drains 118 sont respectivement adressés avec des lignes d'interconnexion 142 et reliés à celles-ci en des prises de contact 142'.

Conformément à l'invention, le dispositif de la figure 3 comporte également des moyens de polarisation du substrat avec une région 138, implantée dans le substrat du caisson 110 et relié en une prise de contact 144' à une ligne 144.

De plus, l'ensemble des points 112 du caisson sont isolés des caissons voisins au moyen d'une tranchée d'isolation 128 qui permet, comme décrit plus loin, d'adresser c'est-à-dire programmer, lire et effacer les points 112 indépendamment du reste du circuit, non représentés.

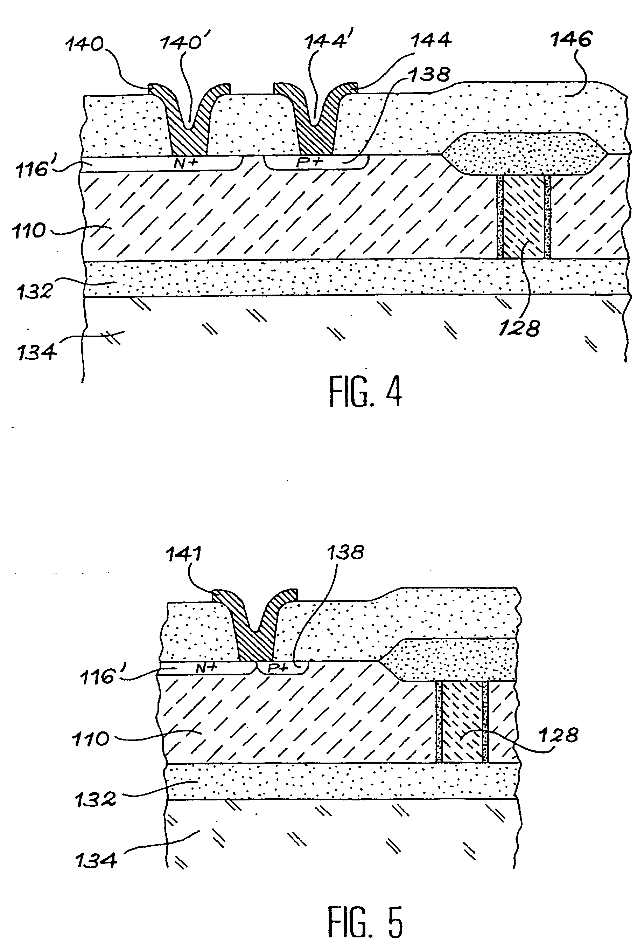

La figure 4, qui est un détail de la figure 3 selon une coupe IV-IV permet de mieux comprendre la réalisation des prises de contact 140' et 144'. Les lignes de connexion 140 et 144 sont isolées du substrat du caisson 110 au moyen d'une couche 146 d'un matériau isolant tel que par exemple du verre dopé au bore et au phosphore. Elles sont reliées respectivement à la région de source 116' (de type N⁺) et à la région 138 (de type P⁺) par les prises de contact 140' et 144'.

On distingue également sur la figure une tranchée d'isolation 128 et une couche isolante enterrée 132.

La figure 5 semblable à la figure 4, montre une variante de réalisation de l'invention, où pour un dispositif tel que celui de la figure 3, les lignes de connexion de la source et du substrat ne sont pas séparées mais communes. Le dispositif ne comporte donc qu'une ligne conductrice 141 reliée à la région de source 116' et à la région 138.

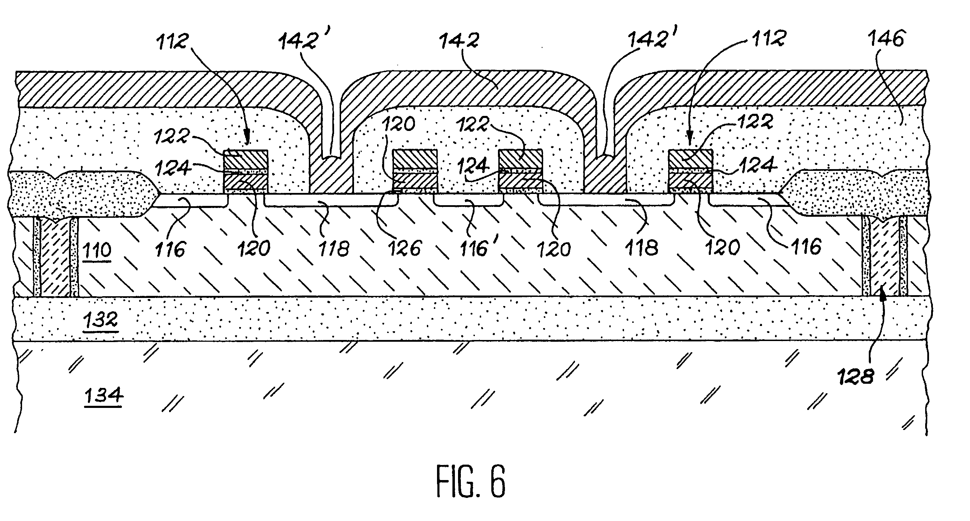

Le dispositif de la figure 3 peut être mieux compris également en se reportant à la figure 6 qui est une coupe VI-VI, c'est-à-dire selon une ligne de connexion de drain 142.

On retrouve des éléments communs aux figures précédentes et en particulier un substrat de base 134 en silicium, par exemple, une couche d'oxyde 132, un substrat actif du caisson 110 et des tranchées d'isolation 128. Les sources 116, 116', les drains 118 sont vus en coupe. Il s'agit de régions implantées dans le substrat du caisson 110. On distingue également les grilles flottantes 120, et les grilles de commande qui ne sont autres que les lignes 122, ainsi que des couches de matériau 124, 126 isolant les grilles entre elles et par rapport au substrat. La ligne de connexion 142 représentée sur la figure est une couche conductrice, par exemple en aluminium, déposée sur une couche isolante 146 qui l'isole des points mémoire 112. Des ouvertures formées dans la couche 146 permettent l'accès aux régions de drain 118 sur lesquelles sont formées les prises de contact 142'.

Le tableau I donne pour un dispositif conforme aux figures 3, 4 et 6 des conditions d'alimentation des points mémoire 112 dans un mode d'écriture, un mode d'effacement et un mode de lecture. Dans le tableau I, les lignes de connexion 142, reliées aux drains sont désignés par "ligne de bit" et les lignes 122, reliées aux grilles, et formant les grilles de commande sont désignées par "lignes de mot".

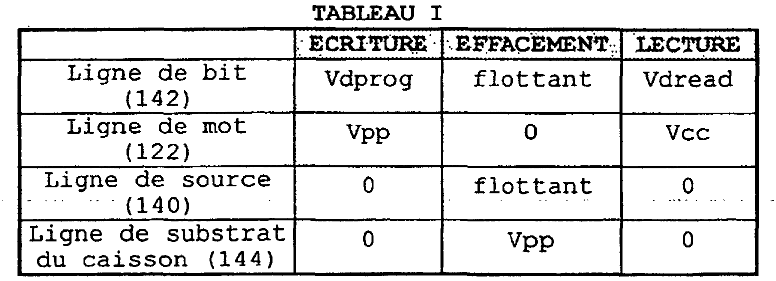

Les abréviations Vdprog, Vdread, Vpp et Vcc désignent respectivement le potentiel de programmation appliqué au drain, le potentiel de lecture appliqué au drain, le potentiel de programmation de la grille, la tension d'alimentation générale.

A titre d'exemple, on peut avoir :
- Vdprog = 7 V,
- Vdread = 1 V,
- Vpp = 12 V,
- Vcc = 5 V

Dans une variante de réalisation du dispositif, qui correspond aux figures 3 et 5, il est possible de relier électriquement la source et le substrat. Dans ce cas, lors de l'effacement, la source et le substrat sont au même potentiel et la source n'est donc pas flottante. Le tableau II résume les conditions d'alimentation (polarisation des points mémoire).

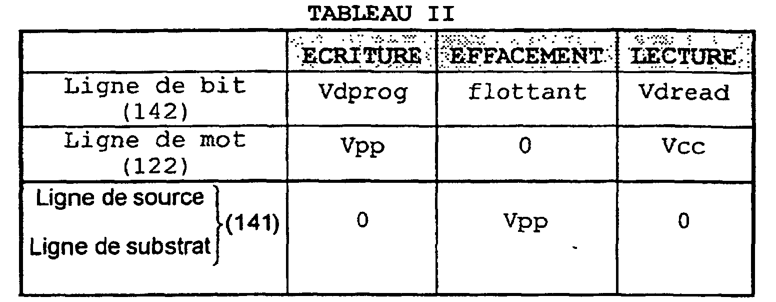

Comme évoqué ci-dessus, l'application d'une tension d'effacement dans la région de canal se fait par l'intermédiaire du substrat du caisson. Ainsi, la tranchée d'isolation qui délimite le caisson définit le nombre de points mémoire qui peuvent être effacés simultanément, l'effacement ayant lieu par conduction du type Fowler-Nordheim (ou effet tunnel).

Comme le dispositif peut comporter une pluralité de zones de mémoire, c'est-à-dire une pluralité de caissons, la ligne d'alimentation du substrat 144 ne doit pas être commune pour toutes les zones de mémoire, sinon tous les points mémoire seraient effacés lorsqu'on porte cette ligne au potentiel Vpp.

Afin de pouvoir effacer sélectivement les points mémoire d'un caisson, entouré par une tranchée d'isolation, un transistor de sélection additionnel peut être prévu.

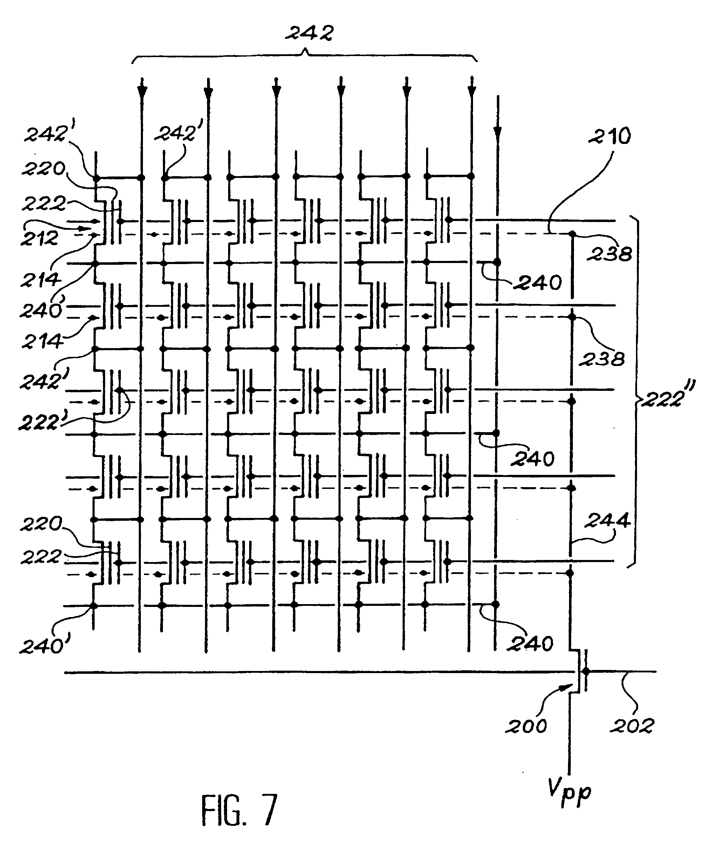

La figure 7 qui est un schéma électronique d'un dispositif conforme à l'invention en donne un exemple. La figure 7 représente une matrice de 6x5 points mémoire 212 ayant chacun une grille flottante 220 et une grille de commande 222.

Les références 240', 242' et 222' désignent respectivement des prises de contact de lignes de connexion 240 sur les sources des points mémoire, de lignes de bit 242 sur les drains des points mémoire et de lignes de mots 222" sur les grilles de commande 222.

Une ligne 244 d'effacement est reliée au substrat en des prises de contact 238. Des lignes virtuelles 210 en trait discontinu reliant les prises 238 aux régions de canal 214 des points mémoire 212 montrent que le potentiel d'effacement est appliqué en ces régions via le substrat du caisson.

En raison du motif répétitif des points mémoire 212, et pour des raisons de clarté, les références ne sont pas systématiquement répétées.

Un transistor de sélection 200 permet d'appliquer une tension d'effacement Vpp au substrat par l'intermédiaire de la ligne 244 lorsqu'une impulsion de sélection de zone de mémoire correspondante est appliquée sur sa grille par l'intermédiaire d'une ligne 202 de sélection.

Ainsi, grâce au transistor 200, il est possible d'effacer les points mémoire 212 indépendamment de ceux d'une autre zone de mémoire non représentée.

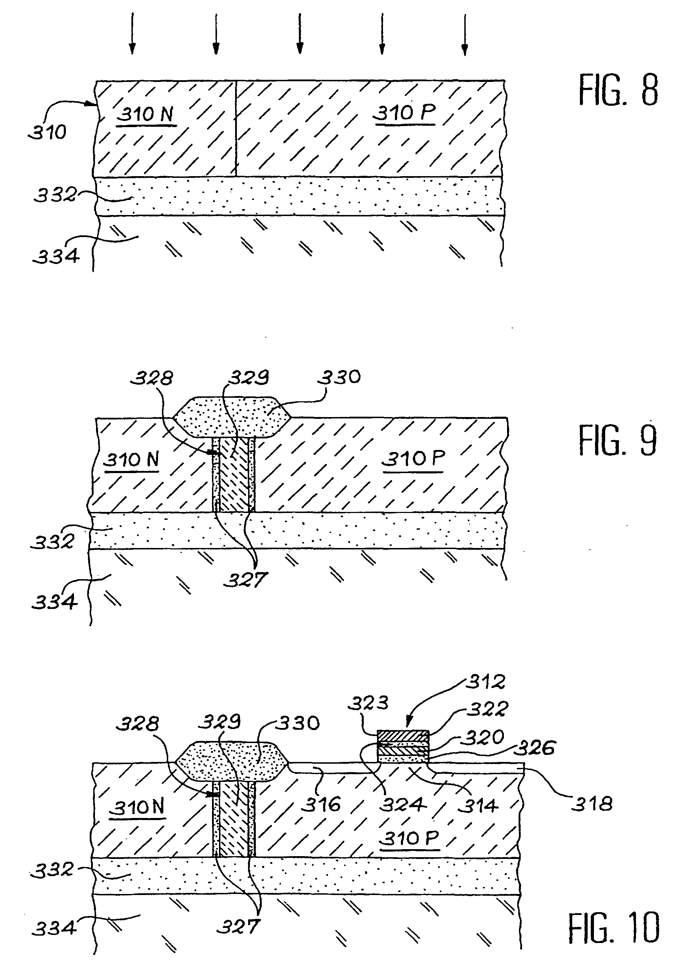

Les figures 8 à 10 montrent à titre d'exemple, des étapes d'un procédé de réalisation d'un dispositif selon l'invention.

Une première étape, illustrée à la figure 8 consiste en la préparation d'un substrat. On forme sur un support de base 334 en silicium une couche enterrée 332 isolante par exemple d'oxyde de silicium, surmontée d'une couche de substrat actif 310 en silicium. Les couches 332 et 310 présentent par exemple des épaisseurs respectivement de 300 nm et 1,2 µm. Cette structure peut être obtenue par exemple par implantation ionique d'oxygène et d'un recuit à haute température ou par report sur une couche d'oxyde de silicium préalablement réalisée sur le support d'un film de silicium. On peut, à ce sujet, se reporter au document (4) référencé à la fin de la présente description.

Le procédé se poursuit par l'implantation dans le substrat d'ions de phosphore et/ou de bore afin de former des parties de substrat 310N et/ou 310P respectivement dopées N et P, ces parties étant désignées par "caissons" et correspondant aux zones de mémoire. Les différents types d'implantation sont réalisés en utilisant des masques. L'implantation ionique est suivie d'un recuit à haute température, par exemple 1100°C. Comme le montre la figure 9, on procède ensuite à une photogravure d'une ou plusieurs tranchées 328. Cette gravure est réalisée par exemple par voie sèche en utilisant comme gaz réactif le gaz SF₆. Une opération d'oxydation thermique à 1000°C sous oxygène sec permet d'oxyder les flancs 327 des tranchées sur une épaisseur de l'ordre de 100 nm. On réalise ensuite un dépôt en phase vapeur à basse pression (LPCVD, "Low Pressure Chemical Vapor Deposition") de silicium polycristallin 329 sur une épaisseur de 1,5 µm afin d'en emplir complètement les tranchées. Une gravure sèche totale avec le gaz réactif SF₆ permet de ne laisser du silicium polycristallin 329 qu'à l'intérieur des tranchées 328. La tranchée représentée sur la figure 9 permet ainsi avec la couche enterrée 332 d'isoler les caissons 310N et 310P. On peut à titre d'illustration de ces opérations se reporter au document (5) référencé à la fin de la présente description. Des régions d'oxyde de champ 330 sont réalisées par oxydation localisée selon un procédé LOCOS (Localized Oxidation of Silicon).

La fabrication du dispositif se poursuit par la formation de points mémoire 312 et de transistors de sélection non représentés.

Celle-ci comporte l'ajustement des dopages dans les régions de canal 314, la formation d'une couche d'oxyde de grille 326 et la formation des grilles. Les grilles flottantes 320 et de commande 322 sont formées en silicium polycristallin dopé et séparées par un diélectrique 324. Ce diélectrique 324 peut comporter un empilement de trois couches, successivement d'oxyde de silicium, de nitrure de silicium puis d'oxyde de silicium. Par ailleurs, la grille de commande 322 est auto-alignée par rapport à la grille flottante 320.

La formation des grilles peut être complétée en outre par une oxydation de leurs flancs 323. Vient ensuite la formation des régions de source 316, et de drain 318 des points mémoire 312 et des transistors de sélection (non représentés) ainsi que de la région de prise de contact sur le substrat. Ces régions peuvent être formées par implantations d'ions (Arsenic par exemple 3.10¹⁵at/cm² à 60keV pour les régions de type N⁺ et bore par exemple 3.10¹⁵at/cm² à 45keV pour les régions de type P⁺).

Le procédé se poursuit par la réalisation de lignes de connexion reliées notamment au drain et à la source de chaque point mémoire et au substrat de chaque zone de mémoire. On peut se reporter à ce sujet aux figures 1, 3, 4, 5 et 6 déjà décrites.

Un dépôt et fluage d'un verre dopé au bore et au phosphore (voir références 46, 146) assure l'isolation des lignes de connexion par rapport aux grilles en silicium polycristallin et au substrat. Dans cette couche sont gravés des trous de contact pour réaliser des prises de contact. La réalisation des prises de contact comporte par exemple la métallisation des trous de contact par dépôt d'une bicouche (Ti/TiN) réalisée par pulvérisation cathodique puis leur remplissage avec du tungstène.

Une couche d'alliage Al-Cu avec 0,5% de cuivre est déposée, puis gravée, pour former les lignes de connexion elles-mêmes. Une couche de passivation en verre dopé au phosphore peut être déposée sur l'ensemble de la structure.

Des plots de soudure sont alors gravés dans cette couche pour accéder aux lignes de connexion.

### DOCUMENTS CITES DANS LA DEMANDE

***(1)***
   US-A-4 783 766
***(2)***
   "Comparison of Current Flash EEPROM Erasing Methods : Stability and How to control" de K. Yoshikawa et al., IEDM 92, pages 595 à 598.
***(3)***
   "A 90ns One-Million Erase/Program Cycle 1-MBit Flash Memory" de Virgil Niles Kynett et al., IEEE Journal of Solid-State Circuits, vol. 24, n°5, October 1989, pages 1259-1263.
***(4)***
   FR-A-2 681 472
***(5)***
   "The Implementation of a Commercial Thick Film SOI Process", de Kevin Yallup et al., pages 43-63.
***(6)***
   Pal. Abs. Jap., vol. 16, n° 188 et J-A-4025077
***(7)***
   US-A-5 313 086

## Revendications

1. Dispositif à mémoire non-volatile, électriquement effaçable, comportant dans au moins une partie (10, 110) d'un substrat, dite zone de mémoire, au moins un point mémoire (12, 112, 212) du type à grille flottante comprenant une source (16, 116) et un drain (18, 118) séparés par une région de canal (14, 114, 214), le substrat étant formé par la couche supérieure d'une structure du type silicium sur isolant SOI, **caractérisé en ce que** le dispositif comporte en outre, pour chaque zone de mémoire, des moyens (38, 138, 238, 44, 144) d'application d'une tension d'effacement du point mémoire dans la région de canal (14, 114, 214) par l'intermédiaire du substrat qui est d'un type de conductivité unique, et qui est en contact avec la région de canal de chaque point mémoire de la zone de mémoire, et, **en ce que** les moyens d'application d'une tension d'effacement comportent, pour chaque zone de mémoire, une ligne de connexion (44, 144) reliée à la partie de substrat (10, 110) correspondant à la zone de mémoire, pour appliquer la tension d'effacement dans la région de canal par l'intermédiaire dudit substrat.

2. Dispositif à mémoire selon la revendication 1, **caractérisé en ce qu'**il comporte une pluralité de zones de mémoire (10, 11, 110) mutuellement isolées.

3. Dispositif à mémoire selon la revendication 1, **caractérisé en ce qu'**il comporte des transistors de sélection (200) des lignes de connexion (244) pour appliquer des tensions d'effacement sélectivement à chaque zone de mémoire.

4. Dispositif à mémoire selon la revendication 2, **caractérisé en ce qu'**il comporte des tranchées d'isolation (28, 128) gravées dans le substrat pour isoler les zones de mémoire.

5. Dispositif à mémoire selon la revendication 4, **caractérisé en ce que** le substrat présente une structure du type silicium sur isolant, SOI, , les tranchées d'isolation (28, 128) étant gravées dans le silicium et présentant une profondeur suffisante pour atteindre l'isolant, de façon à former dans le substrat des caissons isolés correspondant aux zones de mémoire (10, 11, 110).

6. Procédé de fabrication d'un dispositif à mémoire conforme à la revendication 1, **caractérisé en ce qu'**il comporte les étapes suivantes :
- formation d'un substrat par la réalisation d'une couche semi-conductrice active sur un empilement formé par une couche (332) isolante électrique et un support,
- formation, dans la couche active (310), de parties de substrat (310N, 310P), dites caissons, respectivement de type N et/ou de type P,
- formation dans la couche active de tranchées d'isolation (328) séparant les caissons (310N, 310P) et s'étendant jusque sur la couche isolante (332),
- réalisation d'un ou de plusieurs points mémoire (312) dans les caissons, les points comprenant respectivement un drain (316) et une source (318) formés par implantation d'ions dans la couche active (310P) de part et d'autre d'une région de canal (314), ainsi qu'une grille flottante (320) et une grille de commande (322), mutuellement isolées, formées à la surface de la couche active,
- réalisation de lignes de connexion (40, 140, 42, 142, 44, 144) reliées respectivement au drain (316), à la source (318) et à la grille de commande de chaque point mémoire et à la couche semi-conductrice active (310) de chaque caisson.

7. Procédé selon la revendication 6, **caractérisé en ce que** la formation des caissons (310N, 310P), respectivement d'un type de conduction N et P, comporte une implantation ionique respectivement de phosphore et de bore puis une opération de recuit.

8. Procédé de fabrication d'un dispositif à mémoire avec une couche active (310) de silicium et une couche isolante (332) selon la revendication 6, **caractérisé en ce que** la formation de tranchées d'isolation comporte :
- la gravure de tranchées (328) dans la couche active (310) dont les flancs (327) s'étendent jusqu'à la couche isolante,
- oxydation des flancs (327) sous oxygène sec,
- dépôt dans les tranchées (328) de silicium polycristallin.

9. Procédé selon la revendication 6, **caractérisé en ce qu'**il comporte en outre la formation de zones d'oxyde de champ (330) sur les tranchées (328) avant la formation des points mémoire (312).

## Patentansprüche

1. Elektrisch löschbare nicht-flüchtige Speichervorrichtung mit wenigstens einem Teil (10, 110) eines Substrats, Speicherzone genannt, wenigstens einen Speicherpunkt (12, 112, 212) des Typs mit schwebendem Gate, eine Source (16, 116) und einen Drain (18, 118) umfassend, getrennt durch einen Kanalbereich (14, 114, 214), wobei das Substrat durch die obere Schicht einer Struktur des Typs Silicium-auf-Isolator oder SOI gebildet wird,
**dadurch gekennzeichnet,**
**dass** diese Vorrichtung außerdem für jede Speicherzone Einrichtungen (38, 138, 238, 44, 144) zum Anlegen einer Löschspannung des Speicherpunkts in dem Kanalbereich (14, 114, 214) über das Substrat umfasst, das von einem Typ mit nur einer Konduktivität ist und das Kontakt hat mit dem Kanalbereich jedes Speicherpunkts der Speicherzone, und dadurch, dass die Einrichtungen zum Anlegen einer Löschspannung für jede Speicherzone eine Anschlussleitung (44, 144) umfassen, die mit dem der Speicherzone entsprechenden Teil des Substrats (10, 110) verbunden ist, um die Löschspannung über das genannte Substrat an den Kanalbereich anzulegen.

2. Speichervorrichtung nach Anspruch 1, **dadurch gekennzeichnet, dass** sie eine Vielzahl von gegenseitig isolierten Speicherzonen (10, 11, 110) umfasst.

3. Speichervorrichtung nach Anspruch 1, **dadurch gekennzeichnet, dass** sie Selektionstransistoren (200) der Anschlussleitungen (244) umfasst, die dazu dienen, Löschspannungen selektiv an jede Speicherzone anzulegen.

4. Speichervorrichtung nach Anspruch 2, **dadurch gekennzeichnet, dass** sie in das Substrat geätzte Isolationsgräben (28, 128) umfasst, um die Speicherzonen zu isolieren.

5. Speichervorrichtung nach Anspruch 4, **dadurch gekennzeichnet, dass** das Substrat eine Struktur des Typs Silicium-auf-Isolator oder SOI aufweist, wobei die Isolationsgräben (28, 128) in das Silicium geätzt und ausreichend tief sind, um die Isolationsschicht zu erreichen und in dem Substrat isolierte, den Speicherzonen (10, 11, 110) entsprechende Kassetten zu bilden.

6. Verfahren zur Herstellung einer Speichervorrichtung nach Anspruch 1, **dadurch gekennzeichnet, dass** es die folgenden Schritte umfasst:
- das Herstellen eines Substrats durch die Bildung einer aktiven Halbleiterschicht auf einem durch eine elektrische Isolierschicht (332) und einen Träger gebildeten Stapel,
- das Ausbilden von Kassetten genannten Substratteilen (310N, 310P) jeweils des Typs N und/oder des Typs P in der aktiven Schicht (310),
- das Bilden von die Kassetten (310N, 310P) trennenden Isolationsgräben (328) in der aktiven Schicht, ausreichend tief, um die Isolierschicht (332) zu erreichen,
- das Realisieren eines oder mehrerer Speicherpunkte (312) in den Kassetten, wobei diese Punkt jeweils einen Drain (316) und eine Source (318), erzeugt durch Ionenimplantation in der aktiven Schicht (310P) beiderseits eines Kanalbereichs (314), sowie ein schwebendes Gate (320) und eine Steuerelektrode (322) umfassen, gegenseitig isoliert und erzeugt an der Oberfläche der aktiven Schicht,
- das Herstellen von Anschlussleitungen (40, 140, 42, 142, 44, 144), jeweils verbunden mit dem Drain (316), der Source (318) und der Steuerelektrode jedes Speicherpunkts und mit der aktiven Halbleiterschicht (310) jeder Kassette.

7. Verfahren nach Anspruch 6, **dadurch gekennzeichnet, dass** die Bildung der Kassetten (310N, 310P) mit jeweils einem Leitungstyp N und P eine Phosphor- und Bor-Ionenimplatation und dann eine Temperoperation umfasst.

8. Verfahren zur Herstellung einer Speichervorrichtung mit einer aktiven Siliciumschicht (310) und einer Isolierschicht (332) nach Anspruch 6, **dadurch gekennzeichnet, dass** die Bildung von Isolationsgräben umfasst:
- das Ätzen von Gräben (328) in der aktiven Schicht (310), deren Flanken (327) sich bis zur Isolierschicht erstrecken,
- Oxidieren der Flanken (327) unter trockenem Sauerstoff,
- Abscheiden von polykristallinem Silicium in den Gräben (328).

9. Verfahren nach Anspruch 6, **dadurch gekennzeichnet, dass** es außerdem vor der Bildung der Speicherpunkte (312) die Bildung von Feldoxidzonen (330) auf den Gräben (328) umfasst.

## Claims

1. Device having an electrically erasable, non-volatile memory, comprising in at least one part (10, 110) of a substrate, called the storage area, at least one memory cell (12, 112, 212) of the floating grid type having a source (16, 116) and a drain (18, 118) separated by a channel region (14, 114, 214), the substrate being formed by an upper layer of a silicon on insulator or SOI structure, **characterized in that** the device also comprises for each storage area, means (38, 138, 238, 44, 144) for applying an erasing voltage to the channel region (14, 114, 214) by means of the substrate, which is of the single conductivity type and which is in contact with the channel region of each memory cell of the storage area and **in that** the application means for an erasing voltage comprise, for each storage area, a connection line (44, 144) connected to the substrate part (10, 110) corresponding to the storage area, in order to apply the erasing voltage in the channel region by means of said substrate.

2. Memory device according to claim 1, **characterized in that** it comprises a plurality of mutually insulated storage areas (10, 11, 110).

3. Memory device according to claim 1, **characterized in that** it comprises selection transistors (200) for the connection lines (244) for the application of erasing voltages selectively to each storage area.

4. Memory device according to claim 2, **characterized in that** it comprises isolation trenches (28, 128) etched in the substrate for isolating the storage areas.

5. Memory device according to claim 4, **characterized in that** the substrate has a SOI type structure, the isolation trenches (28, 128) being etched in the silicon and have an adequate depth to reach the insulator, so as to form in the substrate insulated recesses corresponding to the storage areas (10, 11, 110).

6. Process for the production of a memory device according to claim 1, **characterized in that** it comprises the following stages:
- formation of a substrate by producing an active semiconductor layer on a stack formed by an electrically insulating layer (332) and a support,
- formation in the active layer (310) of regions (310N, 310P), known as recesses, respectively of the N type and/or P type,
- formation in the active layer of isolation trenches (328) separating the recesses (310N, 310P) and extending up to the insulating layer (332),
- producing one or more memory cells (312) in the recesses, the cells respectively comprising a drain (316) and a source (318) formed by ion implantation in the active layer (310P) on either side of a channel region (314), as well as a floating grid (320) and a control grid (322), which are mutually insulated and formed on the surface of the active layer,
- producing connection lines (40, 140, 42, 142, 44, 144) respectively connected to the drain (316), source (318) and control grid of each memory cell and to the active semiconductor layer (310) of each recess.

7. Process according to claim 6, **characterized in that** the formation of recesses (310N, 310P), respectively of a N and P conduction type, involves an ion implantation respectively of phosphorus and boron and then an annealing operation.

8. Process for the production of a memory device with an active silicon layer (310) and an insulating layer (332) according to claim 6, **characterized in that** the formation of the isolation trenches involves the etching of trenches (328) in the active layer (310), whose sides (327) extend up to the insulating layer, oxidation of the sides (327) under dry oxygen and deposition of polycrystalline silicon in the trenches (328).

9. Process according to claim 6, **characterized in that** it also comprises the formation of field oxide areas (330) on the trenches (328) prior to the formation of the memory cells (312).
